# EUROPEAN PATENT SPECIFICATION

(11) **EP 0 402 548 B1**
(45) Date of publication and mention of the grant of the patent: **01.06.1994**
(21) Application number: 89311260.7
(22) Date of filing: 31.10.1989
(51) Int. Cl.: H01F 7/02

(54) **Magnetic field generating device for ESR system**
Vorrichtung zur Erzeugung eines Magnetfeldes für ein Elektronspinresonanzsystem
Dispositif pour produire un champ magnétique destiné à un système de résonance de spin électronique

(30) Priority: 16.06.1989 JP 154875/88; 24.08.1989 JP 218233/88
(43) Date of publication of application: 19.12.1990
(60) Divisional application: 93113862.2
(73) Proprietor: SUMITOMO SPECIAL METALS CO., LTD., Osaka-shi Osaka (JP)
(72) Inventor: Nakanishi, Akio Yamazaki Seisakusho, Egawa Shimamoto-cho Mishima-gun Osaka (JP); Konishi, Kenta Yamazaki Seisakusho, Egawa Shimamoto-cho Mishima-gun Osaka (JP); Kobayashi, Takashi Yamazaki Seisakusho, Egawa Shimamoto-cho Mishima-gun Osaka (JP)
(74) Representative: Livsey, Gilbert Charlesworth Norris

(56) References cited:
- EP-A- 0 161 782
- EP-A- 0 284 439
- WO-A-88/06798
- US-A- 4 679 022

## Description

The present invention concerns a magnetic field generating device for an electron spin resonance system (hereinafter referred to as an "ESR system").

ESR systems are generally used in the field of research and development. Since ESR systems can detect unpaired electrons due to natural radiation damage of test objects, and because they can be used to measure the ages of archaeological remains, as well as geological, mineral and fossil remains, they have increasingly been utilised recently in the field of archaeology and earth science.

For the magnetic field generating device forming an essential part of an ESR system, it is usually necessary to form a magnetic field of about 0.3 to 0.4 tesla (3000-4000 gauss) at high accuracy and uniformity in the space in which a test object is arranged and, such type of magnetic field generating device should be capable of varying the magnetic field between the magnetic poles of magnets arranged opposite to each other leaving a desired space therebetween (for the test object to be placed therein) while the magnetic field is made to keep a high degree of uniformity even after having been so varied.

### Description of the Prior Art

In the magnetic field generating device used for ESR systems, electromagnets have usually been employed. It is easy to generate and continuously change a magnetic field in a desired space by continuously varying a current applied to the electromagnets but this involves a drawback that the entire device becomes large-sized and expensive.

Further, there has been proposed a structure using only permanent magnets as a magnetic field generating source so that the magnetic field intensity is changed by changing the opposing distance (length of the space) between the permanent magnets.

However, this structure has also had the disadvantage that when the opposing distance is changed, the degree of uniformity of the magnetic field is impaired due to various causes including the deviation of the axis of one of the opposing permanent magnets from that of the other.

The degree of uniformity of the magnetic field in an ESR system is usually required to be better than 0.01 %, and accordingly, there has not been known a device using a magnetic circuit comprising permanent magnets which is capable of reliably achieving this.

In the view of the above, the present applicant has already proposed a magnetic field generating device for an electron spin resonance ("ESR") system in which two permanent magnets are attached to two arms of a yoke so that such magnets are in opposed spaced relationship and means is provided for varying the magnetic field in the space between such magnets, in which a member is provided between the yoke arms which is in magnetic contact with one of them and is movable towards or away from the other of said yoke arms to leave a variable gap between that movable member and said other yoke arm whereby the magnetic resistance of the magnetic path formed by said permanent magnets and said yoke arms is variable.

However, in the above-mentioned construction, since the change of the magnetic field is great relative to the movement of the movable yoke member, no finely adjustable change of the magnetic field can be obtained. Thus, the correspondence between the movements of the movable yoke member and the change of the magnetic field is not sufficiently accurate that a good measurement of a resonance field at the test gap can be achieved. In short, only coarse adjustment lacking the required precision can be achieved by way of this earlier proposal.

Accordingly, it is an object of the present invention to provide a magnetic field generating device for an ESR system having the capability whereby the magnetic field intensity at the measuring gap may be varied and finely adjusted continuously, with high accuracy and precision, while maintaining the high degree of uniformity of the magnetic field intensity which is required.

Preferably the range of adjustments to be achieved is of the order of ± 10⁻² tesla (100 gauss); and preferably also the adjustment should be so fine, and preferably stepless, that accuracy within ± 10⁻⁴ tesla (1 gauss) can be obtained; always with a uniformity of field at the measuring gap of better than 0.01 %.

Another object of the present invention is to provide a small-sized and inexpensive magnetic field generating device used for an ESR system; while a further object of the present invention is to provide a magnetic field generating device for an ESR system of improved operational efficiency and simplicity.

The present invention is defined in claim 1 and the dependent claims.

In its broadest aspect the present invention provides a magnetic field generating device for an electron spin resonance system in which two permanent magnets are attached to two yoke arms so that said magnets are in opposed spaced relationship and means is provided for continuously varying the magnetic field intensity in the main flux gap located between said magnets, said means comprising a movable yoke member mounted on one yoke arm and movable towards and away from the other yoke arm to leave a continuously variable first auxiliary flux gap between a pole of said movable yoke member and said other yoke arm or between said pole of said movable yoke member and a pole of an opposing yoke member mounted on a said other yoke arm, and the invention is characterised in that said means further comprises
(i) an induction coil placed around said movable yoke member and/or
(ii) at least one additional movable yoke member said at least one additional movable yoke member providing either
   a) a second auxiliary air gap, which is variable independently from the first auxiliary air gap, and which is between a pole of the additional movable yoke member and said other yoke arm or between said pole of said at least one additional movable yoke member and a pole of the at least one additional opposing yoke member which is mounted on said other yoke arm, or
   b) said at least one additional movable yoke member which is variable independently being placed within said movable yoke member and being movable with respect thereto.

Alternatively or in addition, means are preferably provided for applying a magnetic field by means of at least one induction coil to the poles of the members defining the or each auxiliary flux gap, thereby to increase or reduce the flux in said auxiliary flux gap, thus modifying the sensitivity of variations in the magnetic field in the main flux gap in response to movement of said movable yoke members.

Preferably, said movable yoke members are arranged to provide at least two independently variable auxiliary flux gaps.

The invention achieves a magnetic field generating device for an electron spin resonance (ESR) system, with a pair of permanent magnets carried within a fixed yoke, there being a magnetic field generated in a space of constant size defined between the opposed poles of the two permanent magnets and constituting a main flux gap for receiving a test object which is subject to a magnetic field of 0.3 to 0.4 tesla (3000-4000 gauss). This system includes associated with the fixed yoke and arranged in the magnetic flow path which extends through the main flux gap, at least one auxiliary flux gap defined between opposed magnetic poles at least one of which is movable to effect variation of the size of that auxiliary flux gap so as to alter the resistance of the flux path extending through said permanent magnets said yoke and each auxiliary flux gap, and thereby to change the field intensity in the fixed flux gap.

In one practical embodiment of the present invention, permanent magnets arranged in a stationary yoke are used as a magnetic field generating source in a magnetic field generating device for use with an ESR system, and a plurality of movable yoke members are attached to the yoke to define one or more auxiliary spaces or flux gaps that form part of a magnetic path, changing the size of said auxiliary space or spaces being effective to change the magnetic resistance of the magnetic path extending through the permanent magnets without varying the size of the space formed between the two permanent magnets. By these measures, the foregoing object, in particular, change of the magnetic field intensity at high accuracy can be attained by a plurality of movable yoke members, for example, having different amounts of magnetic resistance that can be varied such that they are adjustable individually.

The present invention, according to another aspect, provides a magnetic field generating device for an ESR system, in which a solenoid or induction coil is disposed around at least one movable yoke member for stably varying the magnetic field intensity linearly in the space with improved operability and a DC current is supplied to the solenoid coil to superimpose a weak magnetic field, for example, of about ± 10⁻² tesla (100 gauss) to the space thereby making the magnetic field variable in the space.

By these measures a reliable system is achieved with the capability that the field intensity in the fixed flux gap can be changed continuously with fine adjustment within predetermined limits e.g., in the range of ± 10⁻² tesla (100 gauss) while preserving uniformity of better than 0.01 % in the field intensity in the fixed flux gap where a test object is to be measured. As will be seen below these adjustments can usually be made with a high accuracy of say +/- 10⁻⁴ tesla (1 gauss).

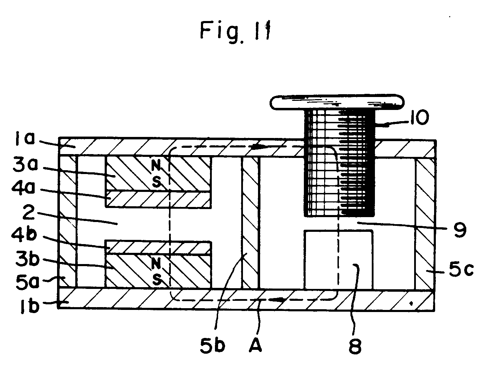

The invention in its various aspects will be further described with reference to the accompanying drawings, in which:-
Figure 1 is a vertical sectional view of a first embodiment of a magnetic field generating device for an ESR system according to the present invention;
Figure 2 is a side elevational view, partially in vertical section, of a second embodiment of a magnetic field generating device for an ESR system according to the present invention;
Figure 3 is a side elevational view, partially in vertical section, of a third embodiment of a magnetic field generating device for use with an ESR system according to the present invention;
Figure 4 is a view partly in vertical cross section of a magnetic field generating device for an ESR system according to this invention and modified to include an induction coil;
Figure 5 is a side elevational view partly in vertical section of the embodiment of a magnetic field generating device for an ESR system shown in Figure 1 but incorporating an induction coil;
Figure 6 is a side elevational view, partially in vertical section, of an embodiment corresponding to Figure 2 but incorporating at least one induction coil;
Figure 7 is a side elevational view, partially in vertical section, of the embodiment of Figure 3 modified to include at least one induction coil;
Figures 8(a) and (b) are vertical cross sectional view and a plan view of one embodiment of a magnetic pole piece for incorporation in an ESR system according to the present invention,
Figures 9 (a) and (b) are vertical cross sectional view and a plan view of a further embodiment of a magnetic pole piece for incorporation in an ESR system according to the present invention;
Figure 10 is a graph showing the change of magnetic field in a space for illustrating the function of movable yokes in a magnetic field generating device for an ESR system shown in Figure 1;
Figure 11 is a side elevational view partly in vertical cross section of a magnetic field generating device for an ESR system previously proposed by the present applicant;
The present applicant has already proposed (see Japanese Utility Model Laid-open Hei 1-104574 published 14 July 1989) a magnetic field generating device for an ESR system which is shown in Figure 11. In Figure 11, a main flux gap 2 of fixed size is formed between a pair of permanent magnets 3a and 3b carried on a pair of stationary yokes 1a and 1b. Magnetic pole pieces 4a and 4b are shown affixed respectively to the opposing surfaces of the permanent magnets 3a and 3b. A test specimen will be disposed and subjected to a magnetic field in the measuring space or main flux gap 2. Detector means not shown will be provided for measuring the characteristics of the test specimen being sought.

Bridging supports 5a, 5b and 5c are disposed for forming and maintaining the pair of stationary yokes 1a and 1b with a predetermined spacing and they are usually made of non-magnetic material. An auxiliary flux gap 9 is formed between a stationary yoke member 8 carried on the yoke arm 1b, and a movable yoke member 10 which is disposed on the stationary yoke 1a. The movable yoke member 10 is adjustable (up and down in the drawing) for varying the distance between the opposing pole surfaces of that yoke member and the stationary yoke member 8 which together define the gap 9, thereby enabling the magnetic resistance of a magnetic path A which includes the permanent magnets 3a, 3b, yoke arms 1a and 1b, movable yoke member 10 and stationary yoke member 8 to be changed within limits. In this construction, if the opposing distance between the movable yoke member 10 and the stationary yoke member 8 is made larger, the magnetic resistance in the magnetic path A is increased to reduce the magnetic field intensity in the space 2. On the other hand, if the opposing distance is reduced, the magnetic resistance in the magnetic path A is decreased to increase the magnetic field intensity in the space 2.

Provision of a magnetic field generating device for an ESR system reduced in size and cost has been enabled by the said earlier proposed device. However, in the above described construction, since the change of the magnetic field is great relative to the rotational movement of the movable yoke member, no fine, precisely adjustable change of the magnetic field can be obtained. This, the correspondence between the rotational movements of the movable yoke member and the change of the magnetic field is not sufficiently accurate that a good measurement of a resonance field at the test gap can be achieved. In short, only coarse adjustment can be achieved by way of this earlier proposal.

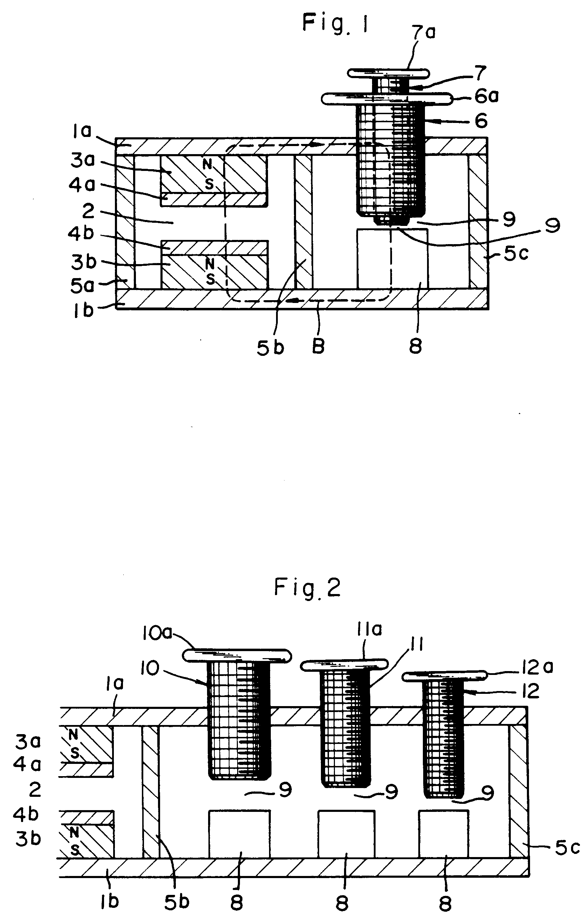

A first aspect of this present invention will now be described, firstly, with reference to Figures 1 to 3. Figure 1 shows a magnetic field generating device for an electron spin resonance (ESR) system, with a pair of permanent magnets 3a, 3b attached to opposed facing surfaces of two fixed yokes 1a, 1b, the two fixed yokes being arranged opposed and spaced apart from one another, there being a magnetic field generated in a space or main flux gap 2 of constant size defined between the opposed poles of the two permanent magnets.

This system includes, associated with the fixed yoke member 1a, not one but two movable yoke members 6 and 7, these movable yoke members being independently movable, both relative to one another and relative to the stationary yokes, so as to define, in the flux path (B) extending through the permanent magnets 3a, 3b, the stationary yokes 1a, 1b and the movable yoke members 6,7, an auxiliary space 9 whose size and shape can be varied, all so as to enable the magnetic resistance of said flux path (B) to be adjusted continuously between predetermined limits.

The auxiliary space 9 is in reality two independently variable auxiliary flux gaps, one defined between the movable yoke member 6 and the stationary yoke member 8, and another defined between the movable yoke member 7 and the stationary yoke member 8. Each movable yoke member 6, 7 is adapted continuously to change the magnetic resistance in the magnetic path. But preferably, and in order to be able to attain a markedly finer degree of precision in adjustment as compared with prior proposals, these movable members comprise a coarsely movable screw bolt 6 of large diameter together with a finely movable screw bolt 7 of smaller diameter. These may be disposed coaxially as shown in Figure 1. In such a system, adjustment of the magnetic field intensity in the measuring gap 2, is first made by forwarding or backwarding the coarsely movable screw bolt 6, followed by fine adjustment by forwarding or backwarding the finely movable screw bolt 7 within the larger screw-bolt 6. By these means change of the size and shape of the auxiliary flux gap 9 can be changed to modulate the magnetic resistance in the system.

A plurality of such movable yoke members can be optionally constituted, for example, by a plurality of coaxially disposed screw bolts each of different diameter and screw pitch as in the case of the screw bolt shown in Figure 1. Alternatively screw bolts of identical or different diameter with identical or different screw pitch may be disposed at required positions as shown in Figure 2, attached to a pair of stationary yoke arms constituting part of a magnetic path, so long as the distance between the opposing surfaces can be changed to vary the magnetic resistance.

In accordance with particular requirements and after making due tests, any number of movable yoke members (6, 7, 10, 11 or 12) can be arranged on the stationary yokes. This may be instead of or in addition to the construction or arrangement shown in the foregoing examples. For example, a plurality of movable yoke members with different diameter may be arranged in parallel, or a plurality of movable yoke members of smaller diameter may be arranged around a movable yoke member of large diameter. The movable yoke members may be arranged on one or both of the fixed yokes, in a line, in a triangle, four-square, in a circle, or in any other convenient disposition.

For forming a magnetic field which is uniform and varies with precise control and accuracy, over a wide range, in a flux gap or measuring space 2 defined between permanent magnets, it is desirable to dispose the movable yokes on the stationary yokes such that they are brought closer together or moved further apart in symmetry with the central plane of the main flux gap 2. This means in effect that preferably, the lengths and resistances of the magnetic paths on the two opposite sides of the flux gaps constituted by the spaces 2 and 9 are substantially equal and symmetrical.

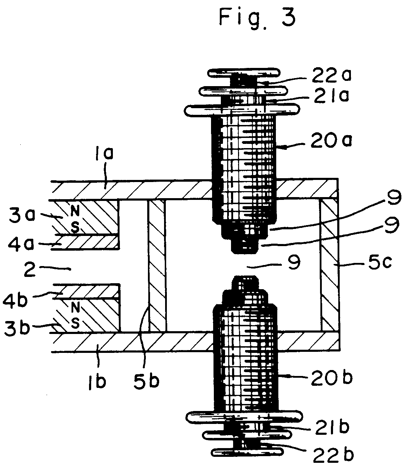

Thus as shown in the construction of Figure 3, a magnetic field which is uniform and varies over a wide range can be formed in a main flux gap 2 between permanent magnets 3a and 3b by disposing a plurality pair of movable yoke members on a pair of yoke arms 1a and 1b so as to be brought closer and apart from each other to define a variable space (which in reality is made up of three individually variable auxiliary flux gaps 9) which is disposed in symmetry with the central plane of the space 2, all such that the magnetic paths on the two opposite sides of the flux gaps constituted by the flux gaps 2 and 9 are substantially equal and symmetrical.

The method of continuously varying the distance between the opposing surfaces of the poles defining the auxiliary flux gap(s) 9 (in Figures 1 to 3, the surfaces of the movable yoke members and the stationary yoke members 8) can be attained by a construction, as shown in Figures 1, 2 and 3, in which movable yokes are disposed coaxially or at a predetermined position in perpendicular to the central plane of the space 2 and an opposing distance between the movable and stationary yoke members is changed by the rotation of a bolt.

When the size of the or each auxiliary flux gap 9 is changed, e.g. the distance between the opposing pole surfaces of the yoke members is changed, the magnetic field in the main flux gap 2 defined between the permanent magnets 3a and 3b, can be varied continuously and steplessly with fine adjustment and with a high degree of precision. But it is desirable to take the following points into consideration in order to linearly vary the magnetic field in the main flux gap while maintaining at a high accuracy i.e. of less than ± 10⁻⁴ tesla (1 gauss).

Thus it should be noted that the change in the distance between the opposing surface of a pair of movable yoke members is not always in a proportional relationship with the change of the magnetic field in the space, and accordingly for varying the magnetic field at a desired accuracy, it is desirable to monitor changes in the magnetic field intensity by means of known measuring means. Control of the closing or opening movements of a pair of movable yoke members can then be achieved based on the detected values.

In the present invention, the shape of the fixed yoke arms to which permanent magnets are attached may be optional, for example, in the form of a square plate or the like, depending on the shape of the permanent magnets used, magnetic characteristics, etc.

For the permanent magnets serving as a magnetic field generating source, it is preferred to select a known material, shape, etc., for example, magnets of a rare earth group or of a ferritic material, depending on the required magnetic field intensity and the size of the device.

In particular, where the reduction in the size is required, it is desirable to use FeB-R series magnet (in which R means rare earth element mainly composed of Nd and Pr) (for example, NEOMAX, trade name: manufactured by Sumitomo Special Metal Co) having a high energy source. For each permanent magnet, a plurality of block form permanent magnets may be combined and integrated depending on desired size and configuration.

Further, there may be attached a magnetic pole piece to each of the opposing surfaces of the pair of permanent magnets so as to improve the degree of uniformity of the magnetic field according to necessity. The magnetic pole piece contributes to the moderation of the scattering in the magnetic properties of the permanent magnets and contributes to effective concentration of magnetic fluxes in the space constituting the main flux gap, in particular, in the case where a plurality of block-form permanent magnets are employed.

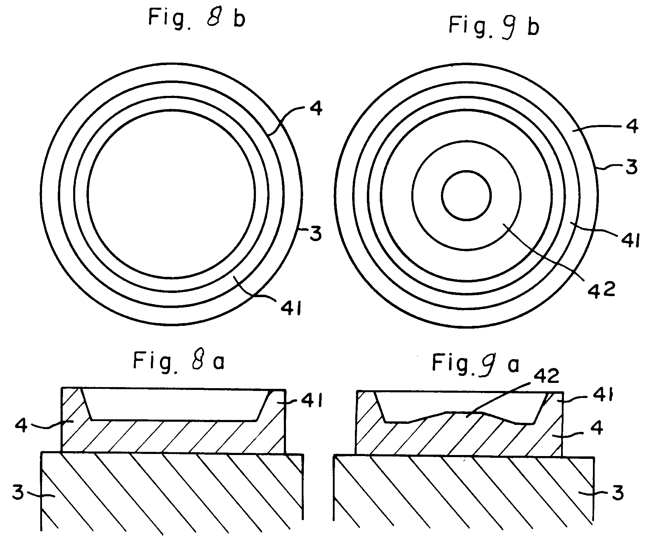

For the construction of the magnetic pole pieces, and as shown in Figures 8 and 9, it is desirable to dispose an annular protrusion 41 having a trapezoidal cross section at the periphery of the magnetic pole piece 4 and/or dispose a convex protrusion 42 having a trapezoidal cross section at the central portion. Further, there may also be employed various other constructions, such as the provision of a plurality of magnetic pieces for adjusting the magnetic field, disposed at a required position on the opposing surfaces of the space between the magnetic pole pieces 4 as required.

For use in an ESR system, it is necessary to linearly vary the magnetic field within a range of up to about ± 10⁻² tesla (100 gauss). However, such a change in the magnetic field is intended to be attained accurately, and if reliance is placed only on moving the movable yokes, there may be some instances e.g. in very large or in very small scale systems, where control for the movable yokes is troublesome or that the entire device is over complicated or over expensive or incapable of easy and reliable operation.

In view of this, in another aspect of the present invention, improved performance has been attained by a construction in which a secondary magnetic field is deliberately induced in some or all of the auxiliary (variable) flux gaps by means of solenoid or induction coil devices disposed around the movable yoke means defining such auxiliary flux gaps.

Then by generating a predetermined high magnetic field in a space between opposed pole surfaces of movable yoke members while controlling the distance therebetween; and then by supplying a predetermined DC current to the solenoid coil or coils having adjusted and set the distance between the opposing pole surfaces to a predetermined level, it is possible to modify the flux in the auxiliary flux gap or gaps 9. This in turn modifies the resistance in the flux path of the system with increased sensitivity.

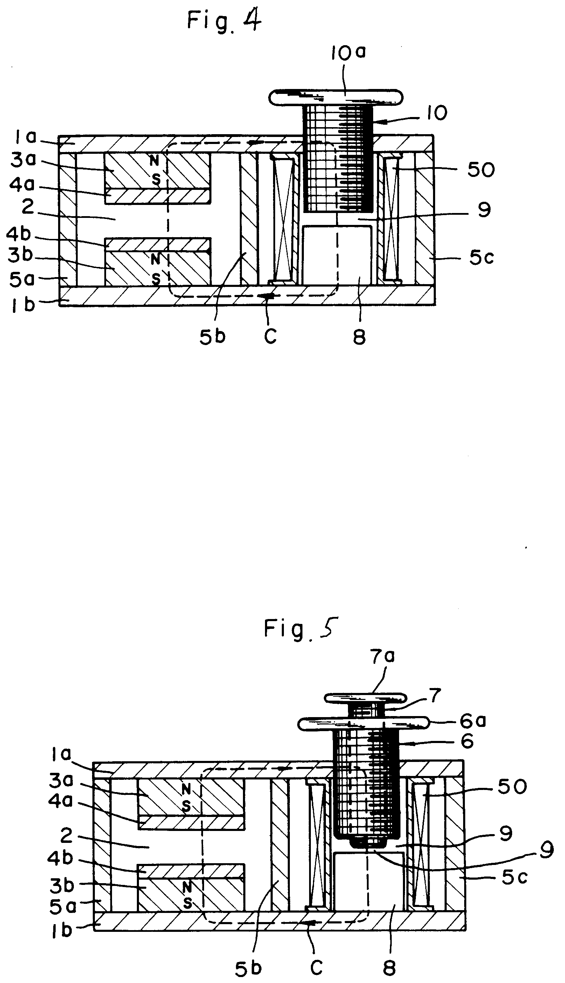

Such constructions will be described below with reference to Figures 4 to 7. By these means it is more easily possible to maintain the magnetic field in the main fixed flux gap 2 with high accuracy and with ability to adjust to within say about ± 10⁻⁴ tesla (1 gauss), without unwanted change of the magnetic field distribution in the space 2, and with the range of adjustment being variable in substantially a linear manner through about ± 10⁻² tesla (100 gauss).

In such a construction, the coil disposed around the movable yoke member merely conducts variation of magnetic field of about +/- 10⁻² tesla (100 gauss), which does not hinder the overall size reduction of the device much.

Further, since the coil is disposed well spaced apart from the permanent magnets, there is no worry that undesirable effects due to the heat generation of the coil are passed to the permanent magnets (for example, change of the magnetic field intensity along with the change of the temperature of the permanent magnets, making the degree of uniformity of the magnetic field unstable).

Next however the embodiments of Figures 1 to 3 will be described more specifically referring to the drawings.

### Figure 1

A pair of plate-like stationary yoke arms 1a and 1b shown in Figure 1 are arranged opposite to each other through supports 5a, 5b and 5c made of nonmagnetic material so as to form a required main flux gap 2 between a pair of permanent magnets 3a and 3b. That is, the disk-like permanent magnets 3a and 3b are attached to the opposing surfaces of the plate-like stationary yokes 1a and 1b with their magnetic poles reversed and magnetic pole pieces 4a and 4b are fixed to the opposing surfaces of the magnets leaving a desired space therebetween.

A coarsely movable yoke member 6 of large diameter is disposed to the upper stationary yoke arm 1a. That is, the coarsely movable yoke member 6 is made of a screwed bolt having threads at a required pitch to the outer circumferential surface and screw-threaded into a hole of the stationary yoke arm 1a. Further, into the coarsely movable yoke member 6, there is coaxially screw-threaded a finely movable yoke member 7 made of a bolt member of small diameter having threads formed at a finer pitch.

When a handle 6a disposed at the top of the coarsely movable yoke member 6 is rotated, the coarsely movable yoke member 6 can be moved continuously in the vertical direction. In the same way, when a handle 7a of the finely movable yoke member 7 is rotated, the finely movable yoke member 7 can be moved continuously.

Further, to the upper surface of the lower stationary yoke 1b, there is attached a stationary yoke member 8 in opposite relationship with the coarsely and finely movable yoke members 6 and 7 leaving auxiliary flux gaps 9 therebetween.

### Operation

With the above-described arrangement shown in Figure 1, there is formed, in the magnetic field generating device for an ESR system, a magnetic flux path shown by the broken line (B) and, when the coarsely movable yoke member 6 is moved forward and backward, the opposing distance between the coarsely movable yoke member 6 and the stationary yoke member 8, that is, the auxiliary flux gap 9 can change continuously so that the intensity of the magnetic field formed in the space constituting the 2 between the magnetic pole pieces 4a and 4b, can be varied continuously.

That is, when the distance between the coarsely movable yoke member 6 and the stationary yoke member 8 is made larger, the resistance of the flux path in the system is increased and the intensity of the magnetic field in the main flux gap 2 becomes weak and vice versa.

By setting a required opposing distance between the coarsely movable yoke member 6 and the stationary yoke member 8 and then moving the finely movable yoke 7 of finer screw pitch forward and backward, the opposing distance with respect to the stationary yoke member 8 can properly be selected to give a fine increase or decrease in the intensity of the magnetic field in the main flux gap 2.

Accordingly, the change of the magnetic field intensity in the main flux gap 2 can be quantitatively recognised to some extent in accordance with the number of rotations for each of the coarsely and finely movable yoke members 6 and 7 from a datum position.

### Figure 2

In the magnetic field generating device for an ESR system shown in Figure 2, three movable yoke members 10, 11, 12 each constituted by a screw-bolt are disposed in a manner analogous to that of the magnetic circuit described above and shown in Figure 1.

Three movable yoke members 10, 11 and 12 of large, medium and small diameters are respectively disposed in parallel to the upper yoke arm la, and the threads of the movable yoke members have a finer pitch as they are of smaller diameter.

Further, three stationary yoke members 8 are attached at the upper surface of the lower yoke arm 1b opposite the three movable yoke members 10, 11 and 12 leaving auxiliary flux gaps 9 therebetween.

When each of handles 1Oa, 11a, 12a disposed at the top end for each of the movable yokes. 10, 11, 12 is rotated, each of the movable yokes can be moved continuously in the vertical direction individually to adjust the opposing distance across the auxiliary flux gap 9 to the respective stationary yoke member 8.

### Operation

With the above-described arrangement, in the same manner as the magnetic field generating device for an ESR system shown in Figure 1, the auxiliary flux gaps 9 between the movable yoke members 10, 11, 12 and the stationary yoke members 8 can be changed continuously so that the intensity of the magnetic field formed in the main flux gap 2 by the magnetic pole pieces 4a and 4b can be varied continuously.

For example, the opposing distance between the movable yoke 12 of small diameter and the stationary yoke member 8 is set to a predetermined or certain value. Then, by setting a required opposing distance between the movable yoke member 10 of greatest diameter and its associated stationary yoke member 8 and then setting the opposing distance between the movable yoke member 11 of medium diameter and its stationary yoke member 8 to a further narrow value, the magnetic field intensity in the main flux gap 2 can be set to a required value with high accuracy.

Further, by forwarding and reversing the movable yoke 12 of smallest diameter by screw-coupling, the magnetic field intensity set to a required value at high accuracy in the main flux gap 2 can be increased or decreased by fine adjustment, so that the change of the magnetic field intensity from the required value can quantitatively be recognised to some extent as the number of rotation for the movable yoke member 12 of smallest diameter.

### Figure 3

Figure 3 shows an embodiment of a magnetic field generating device for an ESR system, in which the movable yoke members comprise a pair of triple bolt members coaxially screw-threaded in a manner analogous to that of the movable yoke members 6, 7 above described and as shown in Figure 1.

A first triplet comprises three movable yoke members 20a, 20b, 20c of large, medium and small diameter which are coaxially screw-threaded one into another and into an upper yoke arm 1a. Again, the threads of the movable yoke members 20a, 20b, 20c have a finer pitch as they are of smaller diameter.

In the same manner, a second, substantially identical, triplet of movable yoke members 20b, 21b and 22b of large, medium and small diameter are coaxially screw-threaded to the lower yoke arm Ib opposite the first triplet so as to form three cooperating pairs of movable yoke members 20a, 20b; 21a, 21b; and 22a, 22b are thus disposed in opposite relationship to form three concentric auxiliary flux gaps 9 which may be arranged to be symmetrical across a central gap plane 16 passing through the main flux gap 2.

When a handle disposed at the top of each of the movable yoke members 20a, 20b; 21a, 21b; 22a, 22b is rotated, each of the yoke members can be moved continuously in the vertical direction so that the opposing distance to each of the paired yoke members can be adjusted individually.

### Operation

A magnetic path is formed in the embodiment detailed in Figure 3 which is somewhat like the path B of Figure 1.

In this case, when a pair of movable yokes 20a and 20b of largest diameter are moved forward and backward by the same number of rotations, the opposing distance between the pair of the movable yokes 20a and 20b, that is, the auxiliary flux gap 9 can remain symmetrical of the central gap plane while that gap size is changed continuously, and this will continuously vary the intensity of the magnetic field formed in the main flux gap 2 by the magnetic pole pieces 4a, 4b.

For example, the auxiliary flux gap between the pair of movable yokes 22a and 22b of smallest diameter may be set to a certain value. Then, after setting the opposing distance between a pair of the movable yokes 20a and 20b of largest diameter and then setting a required further narrow opposing distance between a pair of movable yoke members 21a and 21b of medium diameter, the intensity of the magnetic field of medium diameter, the intensity of the magnetic field in the main flux gap 2 can be set to a required value at high accuracy.

Further, when a pair of movable yoke members 22a and 22b of smallest diameter are moved forward and backward, the intensity of the magnetic field set to a required value at high accuracy in the main flux gap 2 can be increased or decreased by a fine step and the change of the magnetic field intensity from a required value can be recognised quantitatively by the number of rotations for the movable yoke members 22a and 22b of smallest diameter.

Reference will now be made to those embodiments of this invention, shown in Figure 4 through Figure 7,: in which a magnetic field is generated in the or each auxiliary flux gap 9 by means of an induction coil is disposed around a movable yoke member.

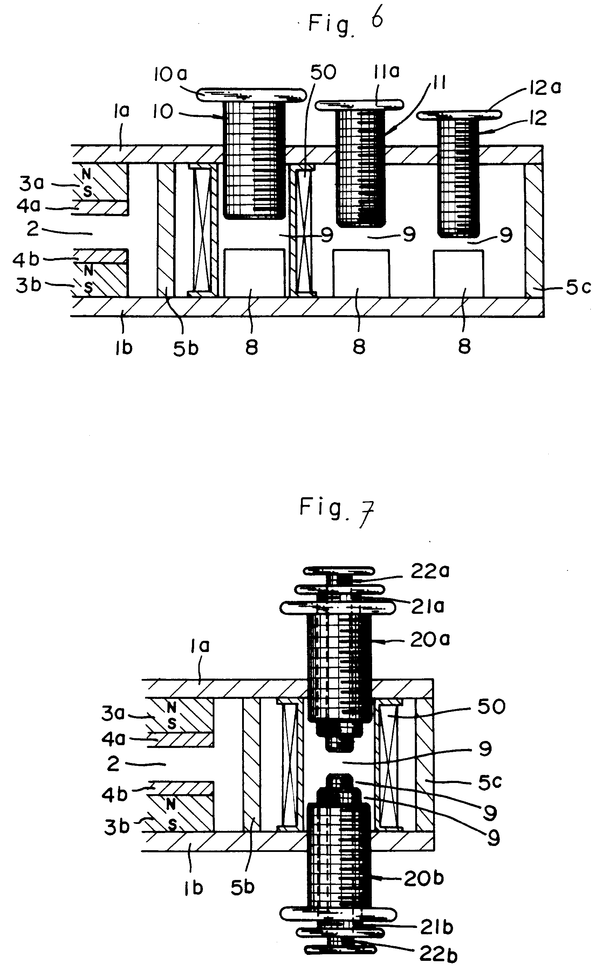

Figures 4 and 5 each show an embodiment in which an induction coil 50 is disposed around a movable yoke member 6 and around a stationary yoke member 8. By this means, a magnetic field can be generated in the auxiliary flux gap 9, which further modifies the resistance of the system and the field created in the main flux gap or measuring space 2. By this measure operational efficiency is greatly facilitated and improved.

Figure 6 shows an embodiment in which a coil 50 is disposed around the movable yoke member 10 of largest diameter among the movable yoke members 10, 11 and 12 and the stationary yoke member 8 in the embodiment of Figure 2.

Figure 7 shows an embodiment in which a coil 50 disposed around the movable yoke members 20a and 20b of largest diameter in the embodiment of Figure 3.

In each of the embodiments depicted in Figures 4 to 7, the induction coil 50 is shown disposed around movable yoke members. However, the disposition of the coil is not necessarily limited only to those dispositions as shown in the drawings and other convenient dispositions can be employed so long as a weak magnetic field can be superimposed through the movable yoke members to the or each auxiliary flux gap 9. The position of each coil is selected depending on the capacity of DC current applied, wire diameter and number of turn of coil, disposition and shape of the movable yoke member, etc.

In the embodiments shown in Figure 4 through Figure 7, a magnetic field of uniform intensity, for example, of about 0.35 tesla (3500 gauss) is generated in the auxiliary flux gap 9 by adjusting the opposing distance between the or each movable yoke member. Then, by applying a DC current to the solenoid coil 50 to superimpose a weak magnetic field of about ± 10⁻² tesla (100 gauss) over the magnetic field in the auxiliary flux gap 9, the magnetic field in the main flux gap 2 can be varied continuously with high precision; and also, the magnetic field intensity can be varied generally in a stable and linear fashion, while at the same time, the high degree of uniformity for the magnetic field intensity in the main flux gap or measuring space 2 can still be maintained.

As shown in Figure 1 through Figure 3 and Figure 4 through Figure 7, in the device according to the present invention, the magnetic field in the main flux gap 2 defined between the opposing permanent magnets can be varied continuously by changing the distance between a movable yoke member and a stationary yoke member, or the distance between a pair of opposed movable yoke members.

Since the size of the main flux gap 2 between the opposing magnetic poles where the object to be measured is set, is fixed, the system is capable of generating a stable uniform magnetic field. However the invention provides further and additional adjustment means whereby fine and precise control can be achieved in each embodiment. Thus in Figures 1 to 3, there are at least two auxiliary flux gaps whose sizes and shapes are variable by means of independently movable yoke members. While in Figures 4 to 7, means are provided for applying a magnetic field in each auxiliary flux gap 9.

The measured results from a test example will now be given.

### EXAMPLE I

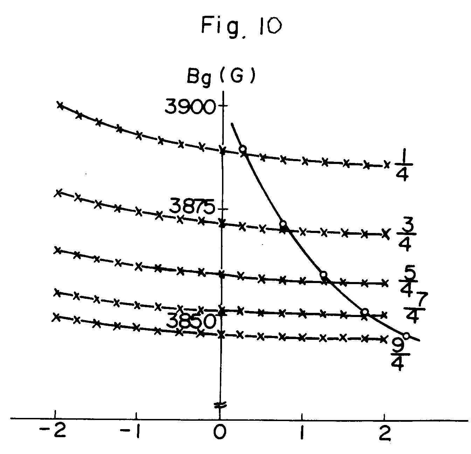

A magnetic field generating device for an ESR system shown in Figure 1 was used in which a coarsely movable screw bolt (6) of 20 mm ⌀ and finely movable screw bolt (7) of 7 mm ⌀ were arranged coaxially. A magnetic field intensity in the main flux gap (2) was measured while changing the separation distance between the movable yoke members and the stationary yoke member (8), and the result is shown in Figure 10 as a relationship of the number of rotations for the coarsely movable screw bolt and the finely movable screw bolt to a magnetic field intensity Bg.

A curve plotted by symbols "o" shows the relationship between the number of rotations for the coarsely movable screw bolt and the change of the magnetic field intensity, and a curve plotted by symbols "x" shows that for the finely movable screw bolt, obtained by rotating and then fixing the coarsely movable screw bolt at a position and then further rotating the finely movable screw bolt. 1/4, 3/4, 5/4, 7/7 and 9/4 attached to the solid line plotted with "x" show the number of rotation for the coarsely movable screw bolt.

As is apparent from Figure 10, while one turn of the coarsely movable screw bolt corresponds to the change of the magnetic field intensity of about 2.5 x 10⁻³ tesla (25 G), one turn of the finely movable screw bolt corresponds to about 2 x 10⁻⁴ tesla (2 G) and, thus, the variation coefficient for the magnetic field intensity relative to the number of rotations is extremely small.

Accordingly by the combination of the number of rotation for the coarsely movable screw bolt and the finely movable screw bolt, the magnetic field in the space can optionally be changed at an accuracy less than 10⁻⁴ tesla (1 G).

In the ESR measurement, since the range for the absorption lines of signals is about 10⁻⁴ tesla (1 G), it is necessary that the change of the magnetic field be modulated and the value has to be determined at an accuracy from the order of 10⁻⁴ tesla to 10⁻⁵ tesla (1 G to 0.1 G).

As apparent from the foregoing embodiment, the magnetic field generating device according to the present invention can sufficiently satisfy such a measuring accuracy and, thus, an ESR system with the magnetic field generating device using permanent magnets can be developed.

By the measures proposed according to this invention as outlined above, it is usually possible to achieve a reliable system, with the capability that the field intensity in the main flux gap can be changed continuously with fine adjustment within predetermined limits e.g., in the range of ± 10⁻² tesla (100 gauss), while preserving uniformity of better than 0.01 % in the field intensity in the main flux gap where a test object is to be measured. As can be seen below these adjustments can usually be made with high accuracy and precision to within say ± 10⁻⁴ tesla (1 gauss).

Attention is directed to Eurpean patent application 93113862.2, divided from this application, which is directed to other magnetic field generating devices.

## Claims

1. A magnetic field generating device for an electron spin resonance system in which two permanent magnets (3a, 3b) are attached to two yoke arms (1a, 1b) so that said magnets (3a, 3b) are in opposed spaced relationship and means is provided for continuously varying the magnetic field intensity in the main flux gap (2) located between said magnets (3a, 3b), said means comprising a movable yoke member (6,10,20a) mounted on one yoke arm (1a) and movable towards and away from the other yoke arm (1b) to leave a continuously variable first auxiliary flux gap (9) between a pole of said movable yoke member (6,10,20a) and said other yoke arm (1b) or between said pole of said movable yoke member (6,10,20a) and a pole of an opposing yoke member (8,20b) mounted on a said other yoke arm (1b), characterised in that said means further comprises
(i) an induction coil (50) placed around said movable yoke member (6,10,20a)
and/or
(ii) at least one additional movable yoke member (7,11,12,21a,22a) said at least one additional movable yoke member providing either
a) a second auxiliary air gap, which is variable independently from the first auxiliary air gap, and which is between a pole of the additional movable yoke member (11,12) and said other yoke arm (1b) or between said pole of said at least one additional movable yoke member (11,12) and a pole of the at least one additional opposing yoke member (8) which is mounted on said other yoke arm (1b), or
b) said at least one additional movable yoke member (7,21a,22a) which is variable independently being placed within said movable yoke member (6,10,20a) and being movable with respect thereto.

2. A device according to claim 1 and further characterized in that said movable yoke members (6, 7; 10, 11, 12; 20a, 21a, 22a; 20b, 21b, 22b) are arranged to provide at least two independently variable auxiliary flux gaps (9).

3. A device according to claim 1 or claim 2 and further characterized in that means are provided for applying a magnetic field by means of at least one induction coil (50) to the poles of the members (6, 8; 7, 8; 10, 8; 20a, 20b; 21a, 21b; 22a, 22b; 30a, 30b) defining the or each auxiliary flux gap (9), thereby to increase or reduce the flux in said auxiliary flux gap (9), thus modifying the sensitivity of variations in the magnetic field in the main flux gap (2) in response to movement of said movable yoke members (6, 7; 10, 11, 12; 20a, 21a, 22a; 20b, 21b, 22b; 30a, 30b).

4. A magnetic field generating device for an ESR system according to any preceding claim, wherein magnetic pole pieces (4) are respectively attached to opposing surfaces of the pair of permanent magnets (3).

5. A magnetic field generating device for an ESR system according to claim 4, wherein an annular protrusion (41) having a trapezoidal cross section is disposed at the periphery of each magnetic pole piece (4).

6. A magnetic field generating device for an ESR system according to any preceding claim, wherein at least one of the plurality of movable yoke members (6, 7; 10, 11, 12; 20a, 21a, 22a; 20b, 21b, 22b;) comprises a bolt member movable forward and backward in a screw-coupling passing through a yoke arm (la, lb).

7. A magnetic field generating device for an ESR system according to claim 6, wherein a plurality of movable yoke members (6, 7; 20a, 21a, 22a; 20b, 21b, 22b;) are arranged coaxially.

8. A magnetic field generating device for an ESR system according to claim 6 or 7, and wherein one of the movable yoke members comprises a coarsely movable screw bolt (6, 10, 20) of a predetermined diameter and another of the movable yoke members (7, 12, 22) comprises a finely movable screw bolt of smaller diameter.

9. A magnetic field generating device for an ESR system according to any preceding claim, wherein a plurality of movable yoke members (10, 11, 12) are disposed in parallel.

10. A magnetic field generating device for an ESR system according to any preceding claim, wherein there is a plurality of movable yoke members (6, 7; 10, 11, 12; 20, 21, 22) which have diameters different from one another.

11. A magnetic field generating device for an ESR system according to any preceding claim, wherein there is a plurality of movable yoke members (6, 7; 10, 11, 12) which are disposed on one of the stationary yoke arms (1a) and a plurality of stationary yoke members (8) are disposed on the other stationary yoke arm (1b) opposite to such movable yoke members.

12. A magnetic field generating device for an ESR system according to any preceding claim, wherein each of a pair of permanent magnets (3) comprises a permanent magnet made of rare earth element.

## Patentansprüche

1. Eine ein Magnetfeld erzeugende Vorrichtung für ein Elektronen-Spin-Resonanzsystem, bei welcher zwei Permanentmagnete (3a, 3b) an zwei Jocharmen (1a, 1b) derart befestigt sind, daß die besagten Magnete (3a, 3b) mit Abstand einander gegenüberliegend angeordnet sind und Mittel zum kontinuierlichen Ändern der magnetischen Feldstärke im zwischen den besagten Magneten (3a, 3b) liegenden Haupt-Flußspalt (2) vorgesehen sind, wobei die besagten Mittel ein an einem Jocharm (1a) befestigtes bewegbares Jochteil (6, 10, 20a) aufweisen, das zu dem anderen Jocharm (1b) hin und von ihm weg bewegbar ist, zur Bildung eines kontinuierlich veränderbaren ersten Hilfs-Flußspalts (9) zwischen einem Pol des besagten bewegbaren Jochteils (6, 10, 20a) und dem besagten anderen Jocharm (1b) oder zwischen dem besagten Pol des besagten bewegbaren Jochteils (6, 10, 20a) und einem Pol eines gegenüberliegenden Jochteils (8, 20b), das an einem besagten anderen Jocharm (1b) befestigt ist, dadurch gekennzeichnet, daß die besagten Mittel weiterhin folgendes aufweisen:
(i) eine Induktionsspule (50) die um das besagte bewegbare Jochteil (6, 10, 20a) herum angeordnet ist
und/oder
(ii) mindestens ein zusätzliches bewegbares Jochteil (7, 11, 12, 21a, 22a), wobei das besagte mindestens eine zusätzliche bewegbare Jochteil entweder
a) einen zweiten Hilfs-Luftspalt aufweist, welcher unabhängig vom ersten Hilfs-Luftspalt veränderbar ist und der zwischen einem Pol des zusätzlich bewegbaren Jochteils (11, 12) und dem besagten anderen Jocharm (1b) oder zwischen dem besagten Pol des besagten mindestens einen zusätzlichen bewegbaren Jochteils (11, 12) und einem Pol des mindestens einen zusätzlichen gegenüberliegenden Jochteils (8) liegt, das an dem besagten anderen Jocharm (1b) befestigt ist, oder
b) das besagte mindestens eine zusätzliche Jochteil (7, 21a, 22a), welches unabhängig veränderbar ist, innerhalb des besagten bewegbaren Jochteils (6, 10, 20a) angeordnet ist und relativ zu diesem bewegbar ist.

2. Eine Vorrichtung nach Anspruch 1 weiterhin dadurch gekennzeichnet, daß die besagten bewegbaren Jochteile (6, 7; 10, 11, 12; 20a, 21a, 22a; 20b, 21b, 22b) so angeordnet sind, daß mindestens zwei unabhängig voneinander veränderbare Hilfs-Flußspalte (9) gebildet werden.

3. Eine Vorrichtung nach Anspruch 1 oder 2 weiterhin dadurch gekennzeichnet, daß Mittel vorgesehen sind zum Anlegen eines Magnetfeldes an die Pole der Bauteile (6, 8; 7, 8; 10, 8; 20a, 20b; 21a, 21b; 22a, 22b; 30a, 30b), welche den oder jeden Hilfs-Flußspalt (9) begrenzen, mit Hilfe mindestens einer Induktionsspule (50) um dadurch den Fluß in dem besagten Hilfs-Flußspalt (9) zu vergrößern oder zu verkleinern und somit die Empfindlichkeit von Veränderungen des Magnetfeldes im Haupt-Flußspalt (2) in Abhängigkeit von der Bewegung der besagten bewegbaren Jochteile (6, 7; 10, 11, 12; 20a, 21a, 22a; 20b, 21b, 22b; 30a, 30b) zu modifizieren.

4. Eine ein Magnetfeld erzeugende Vorrichtung für ein ESR-System nach einem der vorhergehenden Ansprüche, bei welcher jeweils an einander gegenüberliegenden Oberflächen des Permanentmagnetpaares (3) magnetische Polstücke (4) angeordnet sind.

5. Eine ein Magnetfeld erzeugende Vorrichtung für ein ESR-System nach Anspruch 4, bei welcher an der Peripherie jedes magnetischen Polstücks (4) ein ringförmiger Vorsprung (41) angeordnet ist, der einen trapezförmigen Querschnitt aufweist.

6. Eine ein Magnetfeld erzeugende Vorrichtung für ein ESR-System nach einem der vorhergehenden Ansprüche, bei welcher mindestens eines der mehreren bewegbaren Jochteile (6, 7; 10, 11, 12; 20a, 21a, 22a; 20b, 21b, 22b;) ein in einem Durchlaß durch einen Jocharm (1a, 1b) über eine Schraubverbindung angeordnetes vor- und zurückbewegbares Bolzenteil aufweist.

7. Eine ein Magnetfeld erzeugende Vorrichtung für ein ESR-System nach Anspruch 6, bei welcher mehrere bewegbare Jochteile (6, 7; 20a, 21a, 22a; 20b, 21b, 22b;) koaxial angeordnet sind.

8. Eine ein Magnetfeld erzeugende Vorrichtung für ein ESR-System nach Anspruch 6 oder 7, bei welcher eines der bewegbaren Jochteile einen in Grobeinstellung bewegbaren Schraubenbolzen (6, 10, 20) mit vorgegebenem Durchmesser aufweist und ein anderes der bewegbaren Jochteile (7, 12, 22) einen in Feineinstellung bewegbaren Schraubenbolzen mit kleinerem Durchmesser aufweist.

9. Eine ein Magnetfeld erzeugende Vorrichtung für ein ESR-System nach einem der vorhergehenden Ansprüche, bei welcher mehrere bewegbare Jochteile (10, 11, 12) parallel zueinander angeordnet sind.

10. Eine ein Magnetfeld erzeugende Vorrichtung für ein ESR-System nach einem der vorhergehenden Ansprüche, bei welcher mehrere bewegbare Jochteile (6, 7; 10, 11, 12; 20, 21, 22) vorhanden sind, die voneinander verschiedene Durchmesser aufweisen.

11. Eine ein Magnetfeld erzeugende Vorrichtung für ein ESR-System nach einem der vorhergehenden Ansprüche, bei welcher mehrere bewegbare Jochteile (6, 7; 10, 11, 12) an einem der fest angeordneten Jocharm (1a) angeordnet sind und mehrere fest angeordnete Jochteile (8) am anderen festen Jocharm (1b) diesen bewegbaren Jochteilen gegenüberliegend angeordnet sind.

12. Eine ein Magnetfeld erzeugende Vorrichtung für ein ESR-System nach einem der vorhergehenden Ansprüche, bei welcher jedes Paar von Permanentmagneten (3) einen aus einem Seltenerdelement hergestellten Permanentmagneten aufweist.

## Revendications

1. Dispositif engendrant un champ magnétique pour un système de résonance magnétique électronique, dans lequel deux aimants (3a, 3b) permanents sont fixés à deux bras (1a, 1b) de culasse de manière que les aimants (3a, 3b) soient face-à-face et il est prévu des moyens destinés à faire varier en continu l'intensité du champ magnétique dans l'entrefer (2) principal entre les aimants (3a, 3b), ces moyens comprenant un élément (6, 10, 20a) mobile de culasse, monté sur l'un des bras (1a) de culasse et pouvant se rapprocher et s'éloigner de l'autre bras (1b) de culasse pour laisser un premier entrefer (9) auxiliaire continuellement variable entre un pôle de l'élément (6, 10, 20a) mobile de culasse et l'autre bras (1b) de culasse ou entre le pôle de l'élément (6, 10, 20a) mobile de culasse et un pôle d'un élément (8, 20b) opposé de culasse monté sur l'autre bras (1b) de culasse, caractérisé en ce que ces moyens comprennent en outre :
(i) une bobine (50) d'induction placée autour de l'élément (6,10, 20a) mobile de culasse,
et/ou
(ii) au moins un autre élément (7, 11, 12, 21a à 22a) mobile de culasse supplémentaire, cet au moins autre élément mobile de culasse supplémentaire ménageant soit
a) un second entrefer auxiliaire qui est variable indépendamment du premier entrefer auxiliaire et qui se trouve entre un pôle de l'élément (11, 12) mobile de culasse supplémentaire et l'autre bras (1b) de culasse, ou entre le pôle dudit au moins un élément (11, 12) mobile de culasse supplémentaire et un pôle dudit au moins élément (8) opposé de culasse supplémentaire qui est monté sur l'autre bras (1b) de culasse, ou
b) au moins un élément (7, 21a, 22a) mobile de culasse supplémentaire, qui varie indépendamment en étant placé dans l'élément (6, 10, 20a) mobile de culasse et en étant mobile par rapport à celui-ci.

2. Dispositif suivant la revendication 1 et caractérisé en outre en ce que les éléments (6,7; 10,11,12; 20a,21a,22a; 20b,21b,22b) mobiles de culasse sont disposés de manière à ménager au moins deux entrefers (9) auxiliaires variables indépendamment.

3. Dispositif suivant la revendication 1 ou 2 et caractérisé en outre en ce qu'il est prévu des moyens pour appliquer un champ magnétique au moyen d'au moins une bobine (50) d'induction aux pôles des éléments (6,8; 7,8; 10,8;20a,20b; 21a,21b; 22a,22b; 30a,30b) définissant l'entrefer (9) auxiliaire ou chaque entrefer auxiliaire de manière à augmenter ou à diminuer le flux dans l'entrefer (9) auxiliaire en modifiant ainsi la sensibilité des variations du champ magnétique dans l'entrefer (2) principal en fonction du déplacement des éléments (6,7; 10,11,12; 20a,21a,22a; 20b, 21b,22b; 30a,30b) mobiles de culasse

4. Dispositif engendrant un champ magnétique pour un système de résonance magnétique électronique suivant l'une quelconque des revendications précédentes, dans lequel des pièces (4) polaires magnétiques sont fixées respectivement à des faces opposées du couple d'aimants (3) permanents.

5. Dispositif engendrant un champ magnétique pour un système de résonance magnétique électronique suivant la revendication 4, dans lequel il est prévu une protubérance (41) annulaire de section transversale trapézoïdale à la périphérie de chaque pièce (4) polaire magnétique.

6. Dispositif engendrant un champ magnétique pour un système de résonance magnétique électronique suivant l'une quelconque des revendications précédentes, dans lequel au moins l'un de la pluralité d'éléments (6,7;10,11,12;20a,21a,22a;20b,21b, 22b) mobiles de culasse comprend un boulon susceptible d'avancer et de reculer dans un accouplement à vis traversant un bras (1a, 1b) de culasse.

7. Dispositif engendrant un champ magnétique pour un système de résonance magnétique électronique suivant la revendication 6, dans lequel plusieurs éléments (6,7;20a,21a, 22a;20b,21b,22b) mobiles de culasse sont disposés coaxialement.

8. Dispositif engendrant un champ magnétique pour un système de résonance magnétique électronique suivant la revendication 6 ou 7, et dans lequel l'un des éléments mobiles de culasse comprend un boulon (6,10,20) fileté d'un diamètre prescrit et susceptible de se déplacer grossièrement et un autre des éléments (7,12,22) mobiles de culasse comprend un boulon fileté de diamètre plus petit et susceptible de se déplacer d'une manière plus fine.

9. Dispositif engendrant un champ magnétique pour un système de résonance magnétique électronique suivant l'une quelconque des revendications précédentes, dans lequel plusieurs éléments (10,11,12) mobiles de culasse sont montés en parallèle.

10. Dispositif engendrant un champ magnétique pour un système de résonance magnétique électronique suivant l'une quelconque des revendications précédentes, dans lequel il est prévu plusieurs éléments (6,7,10,12; 20,21,22) mobiles de culasse qui ont des diamètres différents les uns des autres.

11. Dispositif engendrant un champ magnétique pour un système de résonance magnétique électronique suivant l'une quelconque des revendications précédentes, dans lequel il est prévu plusieurs éléments (6,7,10,11,12) mobiles de culasse qui sont montés sur l'un des bras (1a) fixe de culasse et plusieurs éléments (8) fixes de culasse sont montés sur l'autre bras (1b) fixe de culasse en regard de ces éléments mobiles de culasse.

12. Dispositif engendrant un champ magnétique pour un système de résonance magnétique électronique suivant l'une quelconque des revendications précédentes, dans lequel chaque couple d'aimants (3) permanents comprend un aimant permanent en élément de terre rare.
